# EUROPÄISCHE PATENTANMELDUNG

(11) **EP 1 475 832 A1**
(43) Veröffentlichungstag der Anmeldung: **10.11.2004**
(21) Anmeldenummer: 03405315.7
(22) Anmeldetag: 05.05.2003
(51) Int. Cl.: H01L 23/48

(54) **Druckkontaktierbares Leistungshalbleitermodul**

(71) Anmelder: ABB Technology AG, 8050 Zürich (CH)
(72) Erfinder: Schneider, Daniel, 8001 Zurich (CH); Trussel, Dominik, 5620 Bremgarten (CH)
(74) Vertreter: ABB Patent Attorneys

(57) **Zusammenfassung**

Bei einem druckkontaktierbaren Leistungshalbleitermodul mit einem oder mehreren Halbleiterchips (1), einer elektrisch leitende Bodenplatte (21), einer elektrisch leitende Deckplatte (22), für jeden Halbleiterchip mindestens einem Kontaktstift (4), welcher eine elektrisch leitende Verbindung zwischen der Deckplatte (22) und dem Halbleiterchip (1) bewirkt und mindestens einem Federelement (3) zwischen Bodenplatte (21) und Deckplatte (22), wird ein Verlust von Federkraft im Kurschlussmodus dadurch erreicht, dass das Federelement (3) ein keramisches Stützelement (31) und ein auf das keramisches Stützelement (31) eine Kraft ausübendes elastisches Element (321) aufweist.

## Beschreibung

### Technisches Gebiet

Die vorliegende Erfindung bezieht sich auf das Gebiet der Leistungselektronik. Sie betrifft ein druckkontaktierbares Leistungshalbleitermodul nach dem Oberbegriff des ersten Anspruchs.

### Stand der Technik

Aktuell verwendete Leistungshalbleitermodule bestehen aus zwei bis sechs kleineren Einheiten, die als Submodule bezeichnet werden. In diesen Submodulen, die für sich betrachtet ebenfalls Leistungshalbleitermodule darstellen, sind sechs bis fünfzehn Halbleiterchips auf einer elektrisch leitenden Bodenplatte angeordnet, wobei jeder Halbleiterchip für sich von einem gefederten Kontaktstift ("Press Pin") kontaktiert wird. Derartige Leistungshalbleitermodule sind im Allgemeinen kurzschlussfest. Unter Kurzschlussfestigkeit versteht man die Tatsache, dass sich im Fehlerfall, beispielsweise im Falle eines Defekts eines ersten Halbleiterchips, zwischen einem ersten Hauptanschluss des Leistungshalbleitermoduls, welcher mit einer ersten Hauptelektrode des ersten Halbleiterchips elektrisch verbunden ist, und einem zweiten Hauptanschluss des Leistungshalbleitermoduls, welcher mit einer zweiten Hauptelektrode des ersten Halbleiterchips elektrisch verbunden ist, ein stabiler Kurzschluss ausbildet. In einem daraus resultierenden Kurzschlussmodus soll zwischen den beiden Hauptanschlüssen ein dauerhafter elektrischer Kontakt mit möglichst geringem Widerstand und möglichst grosser Stromkapazität bestehen. Deswegen spricht die englische Fachterminologie auch von einem "short circuit failure mode", kurz SCFM. Wenn der erste Halbleiterchip ausfällt, so entsteht durch diesen ersten Halbleiterchip also ein Kurzschluss, welcher den ganzen Kurzschlussstrom des Leistungshalbleitermoduls übernimmt. Ein erster Kontaktstift übernimmt somit die gesamte Stromlast des Leistungshalbleitermoduls, welche bis zu einem fünfzigfachen einer Normalbetriebsstromlast entspricht. Durch eine resultierende extrem hohe Belastung ist eine Lebensdauer des ersten Kontaktstifts stark eingeschränkt. Wenn nun der erste Kontaktstift versagt, wird dieser Kurzschluss unterbrochen, und es findet ein Übergang auf und einen zweiten Kontaktstift statt, welcher den Kurzschlussstrom übernimmt. Wenn nun viele der Kontaktstifte nacheinander den Kurzschlussstrom übernehmen können, entspricht dies einer langen Lebensdauer des Moduls im SCFM.

Um dies zu ermöglichen, muss garantiert werden können, dass an das Leistungshalbleitermodul angrenzende Komponenten, insbesondere ein Kühler, beim Übergang keinen Schaden nehmen. In Versuchen wurde jedoch beobachtet, dass bereits nach wenigen Übergängen Schäden am Kühler auftreten. Diese Schäden sind besonders ausgeprägt, wenn viele benachbarte Kontaktstifte oder gar alle Kontaktstifte zerstört sind. Ursache der Schäden sind Lichtbögen, welche durch ein Nachlassen eines Anpressdrucks, mit welchem die elektrisch leitende Bodenplatte an den Kühler gepresst wird, zustande kommen. Der Anpressdruck lässt nach, weil beim Ausfall eines Halbleiterchips im Allgemeinen sowohl dieser als auch der zugehörige Kontaktstift teilweise schmelzen, und somit eine Federkraft abnimmt.

Anstelle von 20 bis 60 Pins, die sequentiell den Strom tragen könnten, können somit nur einige wenige Pins nacheinander gebraucht werden, was eine Gesamtlebensdauer des Leistungshalbleitermoduls auf etwa ein Zehntel eines theoretisch möglichen Wertes reduziert.

### Darstellung der Erfindung

Es ist somit Aufgabe der Erfindung, ein druckkontaktierbares Leistungshalbleitermodul mit mindestens einem Halbleiterchip anzugeben, bei welchem die im letzten Abschnitt genannten Probleme nicht auftreten.

Diese und weitere Aufgaben werden durch ein Leistungshalbleitermodul der eingangs genannten Art mit den Merkmalen des unabhängigen Patentanspruchs gelöst. Weitere vorteilhafte Ausgestaltungen der Erfindung sind in den abhängigen Ansprüchen angegeben.

Beim erfindungsgemässen Leistungshalbleitermodul ist zwischen einer elektrisch leitenden Bodenplatte und einer elektrisch leitenden Deckplatte mindestens ein Federelement vorgesehen, welches ein keramisches Stützelement und ein elastisches Element aufweist, welches eine Kraft auf das keramische Stützelement ausübt.

Aufgrund einer Hitzebeständigkeit keramischer Materialien bleibt das keramische Stützelement auch bei grosser Wärmeentwicklung, welche insbesondere in einem Kurzschlussmodus auftritt, formstabil, so dass ein Nachlassen einer vom Federelement auf die elektrisch leitende Deckplatte bzw. über das keramische Stützelement auf die elektrisch leitende Bodenplatte ausgeübten Federkraft verhindert wird.

In einer bevorzugten Weiterbildung des erfindungsgemässen Leistungshalbleitermoduls ist das elastische Element und das keramische Stützelement in einen Kontaktstift integriert. Dies ermöglicht einen besonders kompakten Aufbau des Leistungshalbleitermoduls.

Diese und weitere Aufgaben, Vorteile und Merkmale der Erfindung werden aus der nachfolgenden, detaillierten Beschreibung eines bevorzugten Ausführungsbeispiels der Erfindung in Verbindung mit der Zeichnung offensichtlich.

### Kurze Beschreibung der Zeichnung

Fig. 1 zeigt schematisch einen Querschnitt durch ein erfindungsgemässes druckkontaktierbares Leistungshalbleitermodul.
Fig. 2 zeigt eine Aufsicht auf einen Schnitt durch das erfindungsgemässe Leistungshalbleitermodul entlang der Linie A-B aus Fig. 1.
Fig. 3a und 3b zeigen zwei zueinander orthogonale Schnitte durch eine bevorzugte Ausgestaltung des erfindungsgemässen Leistungshalbleitermoduls.
Fig. 4a und 4b zeigen zwei zueinander orthogonale Schnitte durch einer weiteren bevorzugten Ausgestaltung des erfindungsgemässen Leistungshalbleitermoduls.
Fig. 5a und 5b zeigen zwei zueinander orthogonale Schnitte durch einer weitere bevorzugten Ausgestaltung des erfindungsgemässen Leistungshalbleitermoduls.
Fig. 6 zeigt einen Schnitt durch eine weitere bevorzugte Ausgestaltung des erfindungsgemässen Leistungshalbleitermoduls.
Fig. 7 zeigt eine Aufsicht auf einen Schnitt entlang der Linie C-D aus Fig. 6.

Die in der Zeichnung verwendeten Bezugszeichen und deren Bedeutung sind in der Bezugszeichenliste zusammengefasst. Grundsätzlich bezeichnen gleiche Bezugszeichen gleiche Teile.

### Wege zur Ausführung der Erfindung

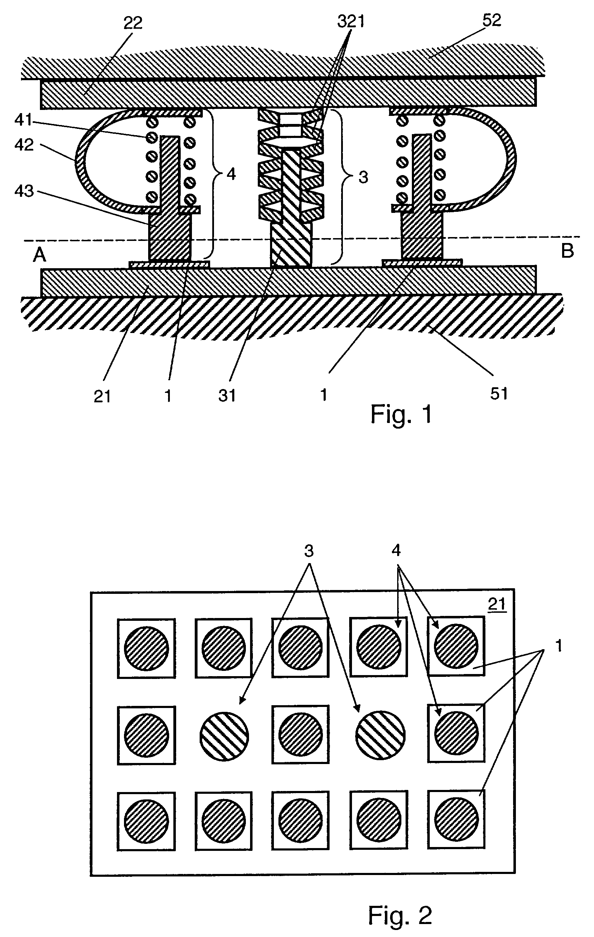

Fig. 1 zeigt schematisch einen Querschnitt durch ein erfindungsgemässes druckkontaktierbares Leistungshalbleitermodul. Auf einer elektrisch leitenden Bodenplatte 21 ist eine Anzahl von Halbleiterchips 1 angeordnet, so dass eine erste Hauptelektrode der Halbleiterchips 1 in elektrischem Kontakt mit der Bodenplatte 21 steht. Für jeden der Halbleiterchips 1 ist ein Kontaktstift 4 vorgesehen, der eine elektrische Verbindung zwischen einer zweiten Hauptelektrode eines jeden der Halbleiterchips 1 und einer elektrisch leitenden Deckplatte 22 bewirkt. Der Kontaktstift 4 umfasst vorzugsweise eine Spiralfeder 41, einen Kontaktbügel 42 und einen Kontaktstempel 43. Zwischen der elektrisch leitenden Bodenplatte 21 und der elektrisch leitenden Deckplatte 22 ist ein Federelement 3 vorgesehen, welches aus einem keramischen Stützelement 31 und einem aus einem Stapel Tellerfedern 321 gebildeten elastischen Element 3 besteht. Ein maximaler Abstand d zwischen der elektrisch leitenden Bodenplatte 21 und der elektrisch leitenden Deckplatte 22 ist dabei vorzugsweise durch eine mechanisch feste Einbauumgebung vorgegeben, beispielsweise durch einen Kühler 51 und eine obere Begrenzung 52, zwischen welche das Leistungshalbleitermodul eingesetzt ist. Der maximale Abstand d kann aber auch durch Seitenwände eines Modulgehäuses, insbesondere durch geeignete Vorsprünge und/oder Vertiefungen, welche die elektrisch leitenden Bodenplatte 21 und/oder die elektrisch leitende Deckplatte 22 teilweise umfassen, vorgegeben sein. Aus Gründen der Übersichtlichkeit sind Seitenwände in der Fig. 1 nicht gezeigt. Vorzugsweise beträgt eine erste Federkraft, welche das Federelement 3 auf die elektrisch leitende Deckplatte 22 und über das keramischen Stützelement 31 auf die elektrisch leitende Bodenplatte 21 und die elektrisch leitende Deckplatte 22 ausübt, etwa 500N bist 1000N, und ist von vergleichbarer Grösse oder grösser als eine entsprechende zweite, von den Spiralfedern ausgeübte Federkraft.

Fig. 2 zeigt eine Aufsicht auf einen Schnitt durch das erfindungsgemässe Leistungshalbleitermodul entlang der Linie A-B aus Fig. 1. Die Halbleiterchips 1 sind dabei in einer regelmässigen Matrix angeordnet, wobei an Leerstellen, an welchen sich keine Halbleiterchips 1 befinden, Federelemente 3 vorgesehen sind. Dies ermöglicht eine flexible Herstellung von Leistungshalbleitermodulen mit einer variierenden Anzahl von Federelementen 3, und gewährleistet eine gleichmässige Verteilung der ersten Federkraft auf die auf die elektrisch leitende Deckplatte 22 bzw. die elektrisch leitende Bodenplatte 21.

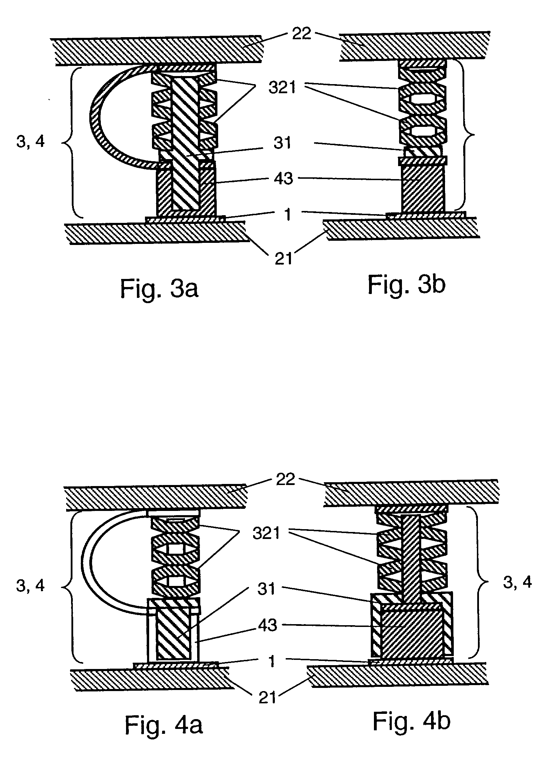

Fig. 3a und 3b zeigen zwei zueinander orthogonale Schnitte durch eine bevorzugte Ausgestaltung des erfindungsgemässen Leistungshalbleitermoduls. Das Federelement 3 ist hier in den Kontaktstift 4 integriert. Zu diesem Zweck weist der Kontaktstempel 43 eine Aussparung auf, in welche das keramische Stützelement 31 eingesetzt ist. Bei einem Aufschmelzen des Kontaktstempels 43 und eventuell des Halbleiterchips 1 trifft das keramische Stützelement 31 auf den Halbleiterchip 1 oder die elektrisch leitende Bodenplatte 21 und verhindert so einen Totalverlust der ersten Federkraft. Eine Länge a eines Fussendes des keramischen Stützelements 31 ist dabei vorteilhaft so bemessen, dass die erste Federkraft nach einem Aufschmelzen des Kontaktstempels 43 und eventuell des Halbleiterchips 1 noch zwischen etwa 40% und 60% ihres ursprünglichen Wertes vor dem Aufschmelzen beträgt.

Fig. 4a und 4b zeigen zwei zueinander orthogonale Schnitte durch einer weiteren bevorzugten Ausgestaltung des erfindungsgemässen Leistungshalbleitermoduls. Bei dieser Ausgestaltung ist das keramische Stützelement 31 nicht in eine Aussparung des Kontaktstempels 43 eingesetzt, sondern weist einen u-förmigen Querschnitt auf und umgibt den Kontaktstempel 43. Das Verhalten bei einem Aufschmelzen des Kontaktstempels 43 und eventuell des Halbleiterchips 1 ist identisch zu dem bei den Fig. 3a und 3b beschriebenen.

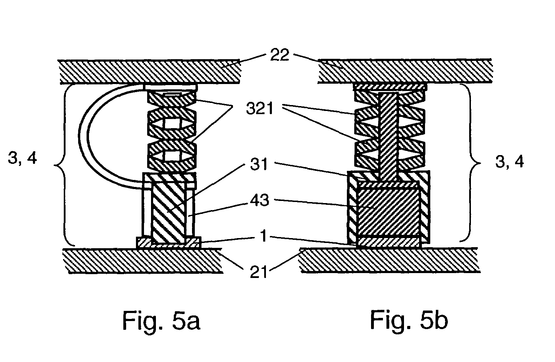

Fig. 5a und 5b zeigen zwei zueinander orthogonale Schnitte durch einer weitere bevorzugten Ausgestaltung des erfindungsgemässen Leistungshalbleitermoduls. Bei dieser Ausgestaltung umgibt das keramische Stützelement 31 nicht nur den Kontaktstempels 43, sondern auch den Halbleiterchip 1. Beim Aufschmelzen des Kontaktstempels 43 und eventuell des Halbleiterchips 1 trifft das keramische Stützelement 31 somit direkt auf die elektrisch leitende Bodenplatte 21.

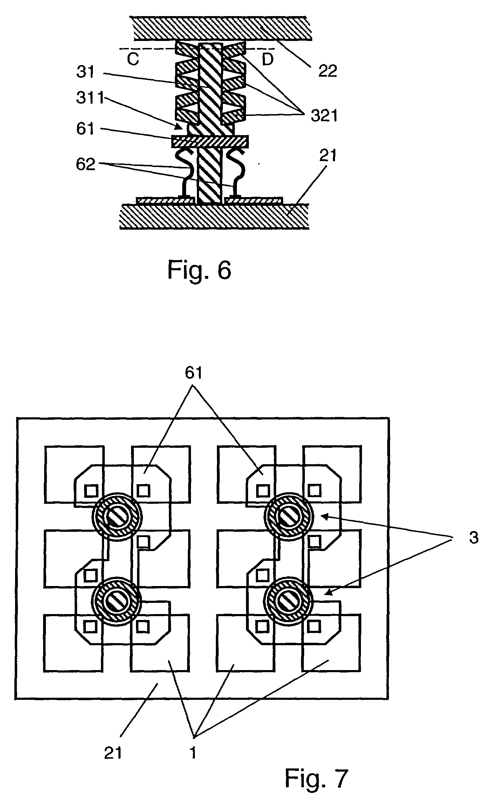

Fig. 6 zeigt einen Schnitt durch eine weitere bevorzugte Ausgestaltung des erfindungsgemässen Leistungshalbleitermoduls. Eine als Positionierungsmittel dienende Mittelscheibe 311 des keramischen Stützelements 31 definiert bei dieser Ausgestaltung einen fixen Abstand eines Steuerkontaktelements in Form einer Gatekontaktbrücke 61 zur elektrisch leitenden Bodenplatte 21. Eine elektrische Kontaktierung eines an jedem Halbleiterchip vorgesehenen Steueranschlusses ("gate") erfolgt über sogenannte Gatefedern 62.

Fig. 7 zeigt eine Aufsicht auf einen Schnitt entlang der Linie C-D aus Fig. 6.

### Bezugszeichenliste

- 1: Halbleiterchip
- 21: Elektrisch leitende Bodenplatte
- 22: Elektrisch leitende Deckplatte
- 3: Federelement
- 31: keramisches Stützelement
- 311: Positionierungsmittel, Mittelscheibe
- 321: Elastisches Element, Tellerfeder
- 4: Kontaktstift
- 41: Spiralfeder
- 42: Kontaktbügel
- 43: Kontaktstempel
- 51: Kühler
- 52: Obere Begrenzung
- 61: Steuerkontaktelement, Gateplatte
- 62: Gatefeder

## Patentansprüche

1. Druckkontaktierbares Leistungshalbleitermodul, umfassend
- einen oder mehrere Halbleiterchips (1),
- eine elektrisch leitende Bodenplatte (21),
- eine elektrisch leitende Deckplatte (22),
- für jeden Halbleiterchip mindestens einen ersten Kontaktstift (4), welcher eine elektrisch leitende Verbindung zwischen der elektrisch leitenden Deckplatte (22) und dem Halbleiterchip (1) bewirkt,
- mindestens ein erstes Federelement (3) zwischen der elektrisch leitenden Bodenplatte (21) und der elektrisch leitenden Deckplatte (22),
**dadurch gekennzeichnet, dass**
- das erste Federelement (3) ein keramisches Stützelement (31) und ein eine Kraft auf das keramische Stützelement (31) ausübendes elastisches Element (321) aufweist.

2. Druckkontaktierbares Leistungshalbleitermodul nach Anspruch 1, **dadurch gekennzeichnet, dass**
- das erste Federelement (3) mit dem keramischen Stützelement (31) und dem elastischen Element (321) in den ersten Kontaktstift (4) integriert ist.

3. Druckkontaktierbares Leistungshalbleitermodul nach Anspruch 2, **dadurch gekennzeichnet, dass**
- der erste Kontaktstift (4) einen Kontaktstempel (43) aufweist und
- das keramische Stützelement (31) bei einem Aufschmelzen des Kontaktstempels (43) eine Expansion des elastischen Elements (321) begrenzt.

4. Druckkontaktierbares Leistungshalbleitermodul nach Anspruch 2 oder 3, **dadurch gekennzeichnet, dass**
- der erste Kontaktstift (4) einen Kontaktstempel (43) aufweist und
- das keramische Stützelement (31) sich über einen Grossteil einer Länge des Kontaktstempels (43) erstreckt.

5. Druckkontaktierbares Leistungshalbleitermodul nach Anspruch 3 oder 4, **dadurch gekennzeichnet, dass**
- das keramische Stützelement (31) in eine im Kontaktstempel (43) vorgesehene Aussparung eingesetzt ist.

6. Druckkontaktierbares Leistungshalbleitermodul nach Anspruch 3 oder 4, **dadurch gekennzeichnet, dass**
- das keramische Stützelement (31) einen Bereich mit einem u-förmigen Querschnitt aufweist, welcher den Kontaktstempel (43) mindestens teilweise umfasst.

7. Druckkontaktierbares Leistungshalbleitermodul nach Anspruch 1, **dadurch gekennzeichnet, dass**
- das keramische Stützelement (31) Positionierungsmittel (311) für ein Steuerkontaktelement (61) aufweist.
